Europäisches Patentamt

European Patent Office

Office européen des brevets

(11) Publication number: **0 336 552**
**A2**

## EUROPEAN PATENT APPLICATION

(21) Application number: 89301902.6

(51) Int. Cl.⁴: **G06F 9/44**

(22) Date of filing: 27.02.89

(30) Priority: 08.04.88 US 179189

(43) Date of publication of application:
**11.10.89 Bulletin 89/41**

(84) Designated Contracting States:
**BE CH DE FR GB IT LI NL SE**

(71) Applicant: **International Business Machines Corporation**
**Old Orchard Road**
**Armonk, N.Y. 10504(US)**

(72) Inventor: **Horn, Gary Randall**
**12046 Lincolnshire**
**Austin Texas 78758(US)**
Inventor: **Shih, Cheng-Fong**
**12225 Cabana Lane**
**Austin Texas 78727(US)**

(74) Representative: **Hawkins, Anthony George Frederick**
**IBM United Kingdom Limited Intellectual Property Department Hursley Park**
**Winchester Hampshire SO21 2JN(GB)**

(54) Identifying program units in an operating environment in a computer.

(57) In a computer operating system environment, program units are identified. Applications execute multiple loadable program units. The operating system permits the applications to externally reference to segments not included in the application's executable code through dynamic linking. These external references are application program interface calls to special program dynamic link libraries, DLLs, which contain run-time API function code. External references of subsequent applications referencing the same function are resolved to the same selector and offset. Only one copy of application program interface code is thereby required for a plurality of applications. Each DLL has a dynamic link identifier function, DLIF, as an entry point within the DLL. The DLIF allows programs to be written calling routines which provide selectors for each DLL in the respective program. A program provides display of all DLLs by name with respective selectors. Another program takes a selector reported to the system kernel upon abnormal application termination and returns the DLL identification including the number of the selector within the DLL. An application program interface to the system kernel thereby identifies code selectors for a given DLL file or, alternatively, identifies a DLL file given a code selector.

PHYSICAL MEMORY 24

DLL SEGMENT 2
25

GDT 20

TABLE 4
26
DLL SEGMENT 4
DLIF 27
DUMMY FUNCTION

24
22
23

DLL SEGMENT 3
28

TABLE 2
29
GETSEL FUNCTION

FIG. 3

## IDENTIFYING PROGRAM UNITS IN AN OPERATING ENVIRONMENT IN A COMPUTER

This invention relates generally to information processing systems and, more particularly, to operating systems and subsystems therefor and applications implemented as multiple loadable/executable program units.

Initially in the development of personal computer systems, the operating systems therefor were such that only single application programs typically directed to performing only one general function or task were capable of running on the system as, for example, in the case of a conventional spreadsheet program. However, from the inherent limitations in such systems, it soon became apparent that it was highly desirable to provide capability to simultaneously run a plurality of application programs, this feature being referred to in the art as "multi-tasking" as, for example, in the case of a spreadsheet program running in conjunction with a word processing program, graphics package, or the like.

Thus various environments were devised supporting this desired function whereby applications were allowed to execute as multiple loadable program units giving rise to shared libraries. Notably among these developments were the creation of powerful operating systems and subsystems including the OS/2™ and AIX™ Operating Systems of IBM Corporation, and the UNIX™ System of AT&T.

One of the desirable features of some of the aforementioned multi-tasking operating environments is that an application program is prevented by the operating system from crashing or otherwise damaging the system. If the application or a subsystem seeks to access memory not allocated thereto, systems were devised whereby the application was terminated and the termination reported.

Such systems typically took advantage of newly developed microprocessor families which provided a protected mode of operation in which physical memory addresses were computed indirectly from a selector and an offset which thereby effects the aforementioned memory isolation and enables the operating system to prevent damage to the system from applications. Operating systems were thereby devised which enabled application programs to have external references to segments that were not included in the application's executable code through "dynamic linking". References to the segments were resolved in special program libraries hereinafter referred to as dynamic link libraries (DLLs) by a loader, i.e., the portion of the operating system's kernel responsible for loading programs from disk into memory.

However, these new systems and subsystems were not without serious problems. Although the aforesaid systems were able to avoid applications damaging the system as was experienced in the prior art, it nevertheless remained desirable for programmers and end users to receive a more detailed indication as to the source of the error which caused the termination (for example, a specified location in a particular subsystem). This was for purposes of debugging (in the case of programmers) and being able to report problems to such programmers in a more detailed fashion (in the case of the end users).

Notwithstanding the decided advantages afforded by multi-tasking systems, at least two distinct problems were associated with the operating system environment under consideration herein for providing more detailed error indications for programs which were implemented using dynamic link libraries. First, given a particular function implemented within a dynamic link library, a programmer could examine a map generated when an application was linked to determine the offset within the dynamic link library of the function in question. However, the programmer must also be able to determine the code selector of the library for purposes of debugging. Unfortunately, though, selector assignments typically are machine dependent and vary on successive executions of applications. Moreover, if an application program was terminated by the system while executing within a dynamic link library, even given that the associated code selector and offset associated with the program function at fault were displayed by the operating system upon such termination, it was necessary for an end user to report the problem to the development organization's programmer whereby the specific dynamic link library giving rise to the termination could be identified precisely.

One solution to the problem of debugging is a source level debugger. An example of this is a product sold by the Microsoft Corporation under the commercial name "Codeview" for IBM/Microsoft C. Such a tool generally makes it unnecessary to know the values of selectors since it allows the programmer to refer to code and data locations mnemonically. However, these tools do not solve the problem for the end user reporting a problem since the end user typically does not have access to the source code or a debugger. Moreover such source level debugging tools are vendor language-dependent and are not readily available for all of the many source languages in use. Also for certain specific problems, an assembler level debugger (requiring knowledge of selector values) is sometimes more desirable (such as when the programs resource requirements exceed the capacity of the source level debugger, or for timing-dependent problems).

Yet another approach to providing more detailed error indication (by identifying specific selectors for a given dynamic link library file, or, alternatively identifying the file from a specified selector), could be effected by writing a device driver accessing internal data areas of the operating system and thence writing a program to obtain the information from the driver. One problem with such an approach well known in the art is that building the drivers is relatively difficult and expensive, involving tedious design, coding, and debugging which can be particularly difficult. Moreover, however, and more serious, such a driver even if designed effectively, would operate along with the operating system itself at the same protection level. The driver would thus have access to all system data segments whereupon the previously noted advantage of the operating system environment under consideration, namely the memory isolation, is thereby defeated.

Accordingly, a solution was sought and highly desired which could be readily and simply implemented by a programmer for applications which would provide for identification of a particular program unit in an environment allowing an application to execute as multiple loadable program units.

According to the invention, there is provided a method of operating a computer, within an operating environment wherein an application executes as multiple loadable program units, for identifying one of said program units, comprising the steps of: generating at least one dynamic link library; generating a plurality of code selectors; generating a first code module in said at least one of said dynamic link libraries related to said plurality of code selectors; deriving a first function corresponding to said dynamic link libraries and said plurality of code selectors; and generating an indication corresponding to said first function.

In an embodiment of the invention, detailed hereinafter, an operating system environment is provided allowing applications to execute multiple loadable program units. The system runs in a protected memory mode and permits application programs to externally reference to segments not included in the application's executable code through dynamic linking. Application programs contain these external references by way of application program interface calls to special program dynamic link libraries, DLLs, which contain run-time application program interface function code. A loader portion of the system kernel resolves inter-segment references to segments in the DLLs during load. Each application has a correlative local descriptor table, LDT, containing segments private to the application. The LDT also contains a replica of a system global descriptor table, GDT, which provides all segments available to all tasks in the system. Access to all system segments is thereby provided to the application.

When the loader loads an application, the corresponding DLL is loaded and assigned a selector. The correlative segment is stored in the GDT and LDT by the loader which resolves the address of the function to its selector and offset. External references of subsequent applications referencing the same function are resolved to the same selector and offset. Only one copy of application program interface code is thereby required for a plurality of applications in the multi-tasking environment.

For each DLL, a dynamic link identifier function, DLIF, is included as an entry point within the DLL. The DLIF allows programs to be written calling routines which provide selectors for each DLL in the respective program. A program provides display of all DLLs by name with respective selectors. Another program takes a selector reported to the system kernel upon abnormal application termination and returns the DLL identification including the number of the selector within the DLL.

In this manner, an application program interface to the system kernel identifies code selectors for a given DLL file or, alternatively, identifies a DLL file given a code selector.

The embodiment will now be described in detail, by way of example, with reference to the accompanying drawings, in which:-

Fig. 1 is a block diagram illustrating memory address computation for real and protected modes;

Fig. 2 is a block diagram of a system architecture structure;

Fig. 3 is an illustration of the relationships between a Global Descriptor Table and a Dynamic Link Library;

Fig. 4 is a functional block diagram of a system implementing the functions described with reference to Figs. 1-3.

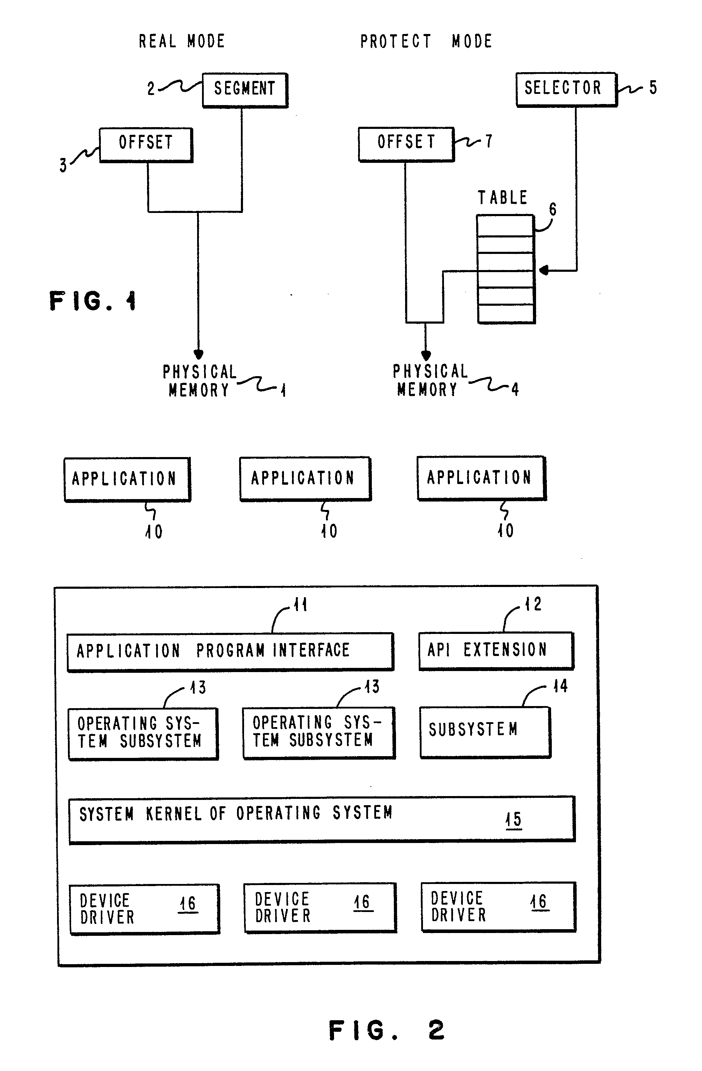

Memory models of some microprocessors provide memory indirection as is well known in the art. As but one example, the memory model of the familiar 286/386 processor family manufactured by the Intel Corporation operating in "protected mode" provides such memory indirection. Referring to Fig. 1, protected mode is distinguished from "real mode" in this regard as follows:

a) In real mode, a physical address 1 is computed directly from a "segment" 2 (identifying a starting location in memory) and an "offset" 3 (identifying the number of bytes from the starting location).

b) In protected mode, a physical address 4 is computed indirectly from a selector 5, which is essentially an index into a table 6, and an offset 7. The table entry for the selector identifies the starting location in memory for the address computation.

3

The protected mode provides several benefits, amongst these being memory isolation whereby applications are prevented from damaging the system.

The table, 6, which is used for all segments available to all tasks in the system, is called the Global Descriptor Table (GDT). Referring to Fig. 2 which illustrates the system architecture structure of the OS/2 operating system of the IBM Corporation, applications access the operating system using the Application Program Interface (API) 11. This system is representative of operating systems which are characterized by their multi-tasking and dynamic linking capabilities, other examples of which include AIX and some versions of UNIX. The term operating system as used hereinafter is intended to refer to such systems. Accordingly, although the OS/2 operating system details may be used herein to describe one embodiment of the subject invention, it should be understood that the invention is not intended to be so limited and contemplates applications generally to other operating systems. Further details regarding the OS/2 operating system may be obtained from Ed Iacobucci, OS/2 Programmer's Guide, McGraw-Hill, 1988 which is incorporated by reference herein.

Included in the GDT are the segments required for the API to the operating system kernel code 15 and common subsystem services 13. One way in which the operating system is designed to be extendable is that applications 10 can write their own subsystems 14, making their APIs 12 a logical extension of the operating system. The segments required for these subsystems are also included in the GDT.

In the operating system the part of the system kernel responsible for loading programs from other media such as a hard file into memory is called the loader. The operating system enables application programs to have external references to segments that are not included in the application's executable code (EXE file) through "dynamic linking". The loader can resolve references to segments included in special program libraries called Dynamic Link Libraries (DLLs). The entire API (and its extensions) is based on dynamic linking. All of the run-time API code is contained in DLLs. When a program is loaded that contains an external reference to a DLL (e.g. an API call), the loader resolves the inter-segment references. Each application in the preferred embodiment has its own descriptor table, called a Local Descriptor Table (LDT), containing segments private to the application, as well as a replica of the GDT, giving the application access to system segments.

From the foregoing, in summary, it will be noted that the run-time code for an API function is contained in a DLL. Examples of such API functions include reading and writing files. If an application contains a call to this function, the application's EXE file contains only an external reference to the function. When the loader loads the application, it also loads the DLL as required (assigning it a selector and storing the actual segment in the GDT and LDT) and resolves the address of the function to its selector and offset. Subsequent applications referencing the same function have their external references resolved to the same selector and offset. Thus only one copy of the API code is required for all applications in the multi-tasking environment.

One of the desirable features of a multi-tasking operating environment is that an application program cannot bring down the system. Because protected mode provides memory isolation, the operating system can prevent applications from damaging the system. If an application (or a subsystem) attempts to access memory that is not allocated it, the system terminates the application and reports the protection violation along with information that can be used to correct the problem. This information contains, among other items, the code selector and offset at which the program attempted the illegal operation.

The ability to implement applications as extensions to the operating system creates a dilemma to the programmer who must correct such problems in the code. If an application program is terminated, the code selector can easily be mapped to the appropriate code segment of the application using a map generated when the application was linked. This is because segments local to an application are assigned the same selectors each time the application executes. However, selectors for DLLs are not easily associated with a particular program, and in fact may be different each time the application is executed.

In the operating system environment under consideration herein, for a program that is implemented using DLLs, there are two distinct problems that present themselves to the development organization:

1. Given a particular function within a DLL, a programmer can examine the map and find the offset within the DLL of the function. However, the programmer must also be able to determine the code selector of the DLL for the purpose of debug. It will be noted that selector assignments can vary from machine to machine and even on successive executions of the applications.

2. If the program is terminated by the system while executing within a DLL, given that code selector and offset are displayed or otherwise indicated by the operating system when the termination occurs, a customer must be able to report the problem to the programmer in such a way as to accurately identify from which DLL the termination came.

One way to solve these problems would be for the system kernel to provide an API to identify the selectors for a given DLL file, or identify a DLL file given a selector. Without such a function intrinsic to the operating system, a programmer could provide the function by writing a device driver that accesses operating system internal data areas to determine the information, and then writing a program to get the information from the device driver. However, writing a device driver is a very tedious operation and the code is especially difficult to debug. Furthermore, such a device driver runs at the same protection level as the operating system itself, and thus has access to all system data segments, exposing the memory isolation of the system to being compromised. A simple solution that any programmer could implement for an application is more desirable.

In the present embodiment, for each DLL in a program, a function is included that is an entry point within the DLL (the function is exported by the DLL) called the Dynamic Link Identifier function (DLIF). Each of these functions is defined as:

char far * far pascal fn (void);

Table 1 which follows is the source code in the C programming language of the Dynamic Link Identifier function of the present invention.

### Table 1

```
#include <dos.h>
int getsel (void) ;
static void dummy (void);
char far * far pascal fn ()
{
     int rc;
     void (*fp)() = dummy;
     rc = getsel ()
     FP_OFF(fp) = ((rc - FP_SEG(fp)) >> 4) + 1;
     return ((char far *) fp);
}
static void dummy ()
{
}
```

Referring to Table 1, line 1 includes an operating system header file defining macros for determining the offset and selector portion of a C pointer as shown by the following.

#define FP__SEG(fp) (*((unsigned *)&(fp) + 1))
#define FP__OFF(fp) (*((unsigned *)&(fp)))

Table 2 which follows is the source code in assembler code of a function that returns its code selector.

### Table 2

```
_text       segment byte public  'CODE'
_text       ends
assume      cs: _text
_text       segment
public      _getsel
_getsel     proc far
            push cs
            pop  ax
            ret
_getsel     endp
_text       ends
end
```

Still referring to Table 1 which illustrates implementation of the function, line 2 declares the function getsel, which is defined and implemented in Table 2 as an assembler language routine that returns its code selector (CS register). Line 3 declares a dummy function which is defined on lines 12-14. Line 4 defines the DLIF function itself as required to be an entry point into a DLL, and as returning a 4-byte far pointer, (fp). Line 7 declares fp as a pointer to a function; fp is set to the address of the dummy function immediately following the DLIF. This causes the selector portion of the pointer fp to contain the selector of the DLIF, which should be equivalent to the first selector of the DLL. On line 8 rc is assigned the selector of the getsel function, which should be the last selector of the DLL. On line 9 the number of code selectors for the DLL is calculated by dividing the difference between the selector for the getsel function and the selector for the DLIF function by 16, and adding one. This number is stored in place of the offset in the pointer to the DLIF. On line 10 the variable fp, still containing the selector of the DLIF, and modified to now contain the number of code selectors for the DLL, is returned to the caller.

It will be recalled that when an application (i.e. an EXE file) or dynamic link library (i.e. a DLL file) is linked, the linking process allows the specification of the ordering of modules within the output.

The number of code selectors for the DLL is accurately returned given that the module containing the DLIF is the first module in the link list for the DLL, and the getsel routine is statically linked from a library, and coded with:

_text segment byte public 'CODE'

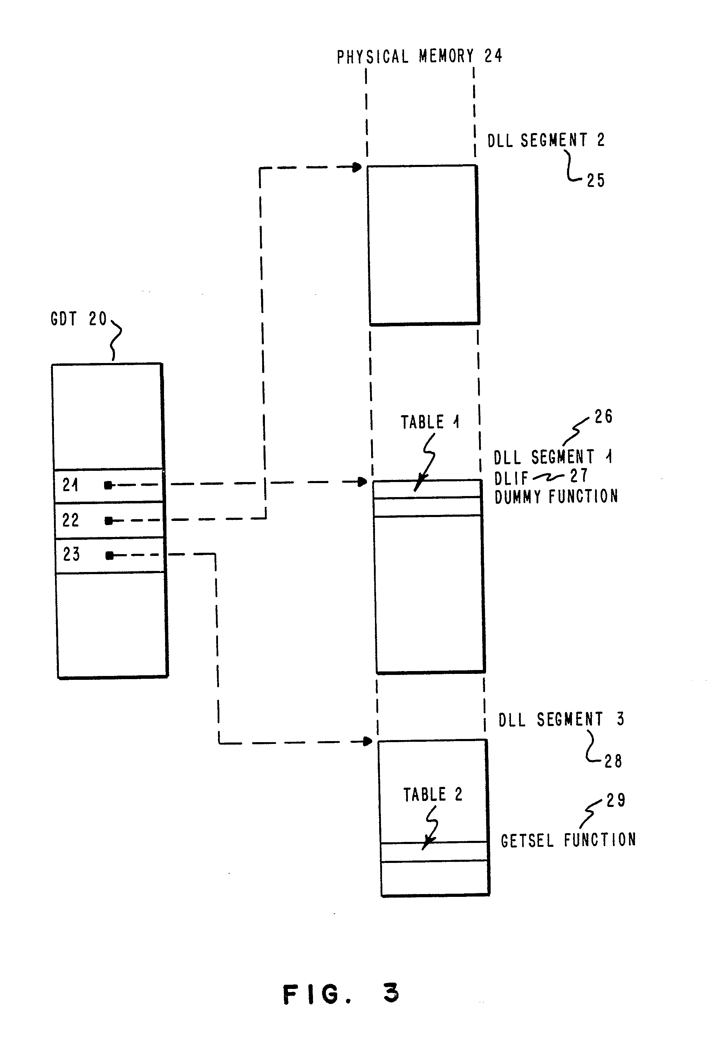

Referring to Fig. 3, this forces the DLIF function 27 to be in the first code segment for the DLL 26. When the DLL is loaded by the loader, it is assigned the first selector for the DLL 21. The linking process also forces the getsel function 29 to be with other C library functions in the last code segment for the DLL 28. When the DLL is loaded by the loader, it is assigned the last selector for the DLL 23. Other selectors are assigned sequentially in between by the loader (as code segment 2 25 in the example), in increments of 16. As shown in Fig. 3, regardless of the physical location of the DLL's code in real memory 24, the assignment of code selectors in the Global Descriptor Table 20 can now be used to identify all the code segments of the DLL. It should be understood that this invention is not intended to be limited to the method of assigning code selectors and contemplates loaders in which other methods are employed such as assigning successive code selectors in increments of eight. Moreover, this invention is not intended to be limited to the described linking process and contemplates linkers in which some other process is required (such as explicitly specifying the segment order by segment name).

The DLIF allows application programs to be written that call these routines and obtain the selectors for each of the DLLs in the program.

Table 3 which follows is a flow diagram of the operation of the present invention for identifying the code selectors of a set of dynamic link libraries.

Table 3

```
Display code selectors of DLLS
  For each DLL in the program
    Call the DLIF of the DLL to obtain the first code
          selector and the number of code segments
    For each code segment of the DLL
      Display the code selector
      Increment the code selector by 16
      Decrement the number of selectors to display
    Endfor
  Endfor
```

Referring to Table 3, a program such as the one illustrated therein can be written to display all DLLs by name with their respective selectors.

Table 4 which follows is the screen print of the output of an embodiment of the function described in Table 3. The screen output for the program is shown in Table 4.

Table 4

Selectors for DLL1 are 5C7 5D7
Selector for DLL2 is 777
Selector for DLL3 is B17
Selector for DLL4 is B67
Selectors for DLL5 are B87 B97
Selector for DLL6 is BB7
Selector for DLL7 is BE7
Selector for DLL8 is CO7
Selector for DLL9 is C67
Selectors for DLL10 are C87 C97 CA7
Selector for DLL11 is CC7
Selector for DLL12 is CF7
Selector for DLL13 is D87
Selector for DLL14 is D47
Selector for DLL15 is D17

Table 5 which follows is is a flow diagram of the operation of the present invention for identifying a dynamic link libraries given a code selector.

Table 5

```
Identify DLL for a given code selector
 For each DLL in the program
  Call the DLIF of the DLL to obtain the first code
            selector and the number of code segments
   Initialize the number of the code segment within the DLL to 1
   For each code segment of the DLL
    If the given code selector is equal to the DLL code selector
     Display the DLL name
     Display the number of the code segment within the DLL
     Exit the loop
    Else
     Increment the DLL code selector by 16
     Increment the number fo the code sement within the DLL
     Decrement the number of selectors to test
    Endif
   Endfor
```

Another program such as the one depicted in the above Table 5 can be written that takes the selector reported by the system kernel when an application is abnormally terminated and return the DLL identification, including the number of the selector within the DLL. To use this program it is necessary to concurrently (when the abnormal termination occurs) be executing another application that references the same set of DLLs as the terminated application. The program described in Table 3 can be used for this purpose. This ensures that the selectors assigned to the DLLs will not be freed and reassigned when the program described in Table 5 is run. It will be apparent that the hereinbefore described functions of the present invention are of great benefit to program developers in problem determination and debugging.

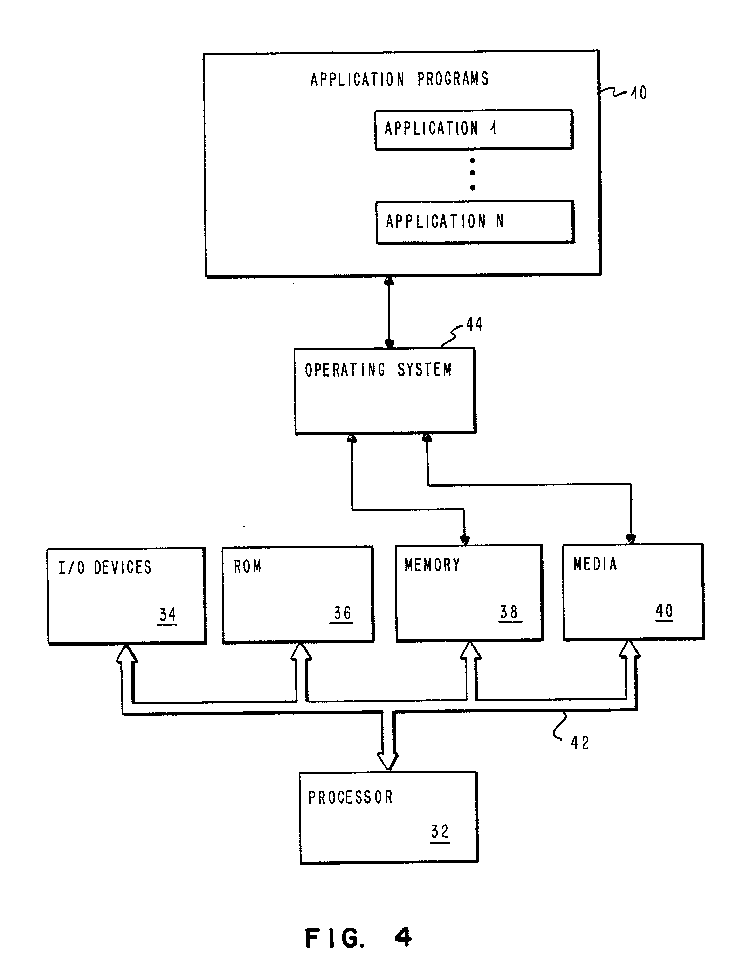

With reference to Fig. 4, a block diagram is shown of a processing apparatus which may be used to run computer programs providing the function of the previously described algorithms, thereby implementing the system of the present invention. The system preferably takes the form of a typical personal computer architecture such as that embodied in the IBM Personal System/2. With respect to this system 30, a microprocessor 32 is provided such as an Intel 80286 or 80386 device which is interconnected to a desired selection of I/O devices 34, ROM 36, memory 38, and media 40 by means of a bus 42. It will be appreciated that in a conventional manner, the bus 42 will be comprised of address, command, and data lines for purposes well known in the art. The I/O devices 34 which may be included in the system 30 of the present invention may include a display such as an IBM Personal System Color Display 8510, a keyboard, mouse or the like for user input, and a printer if desired. It will also be appreciated that for purposes of simplicity, adapters have been omitted from Fig. 4 although it will be appreciated that such adapters for the various devices 34-40 may either be included as part of the IBM Personal System/2 or available as plug in options from the IBM Corporation.

Within the read only memory or ROM 36, the basic input/output operating system or BIOS is stored for execution by the processor 32. The BIOS, as is well known, controls the fundamental operations of the computer system 30. Additionally, an operating system 44 is provided such as OS/2 which will be loaded into memory 38 and will run in conjunction with the BIOS in ROM 36.

Additional information on the Personal System/2 and Operating System OS/2 which may used in a preferred embodiment to implement the system and methods of the present invention may be found in the following reference manuals herein incorporated by reference: IBM Operating System/2 Version 1.0 Standard Edition Technical Reference, IBM Corporation Part No. 6280201, Order No. 5871-AA, Technical Reference Manual, Personal System/2 (Model 80), IBM Corporation, Part No. 68X2256, Order No. S68X-2256; and OS/2 Programmer's Guide, Iacobucci, Ed, McGraw Hill 1988.

In accordance with the invention, an application program 10 is further provided which may be loaded into memory 38 or stored in media 40. This media 40 may be of any conventional form such as a hard file, diskettes associated with a disk drive, or the like. In accordance with OS/2, the data base application program 10 may be considered as an operating system 44 extension and will include numerous functions conventionally associated with a database program providing instructions to the processor 32 so as to enable the system 30 to perform relational database functions as hereinbefore described. The operator may interface with the database program through the various I/O devices 34, such interfacing including entering, accessing, changing, or deleting data from the database and other such tasks. For example, the user may interact with the database program 46 by inputting some form of command such as an SQL command well known in the art via the keyboard, whereupon the system 30 will query the data resident in the database and output the desired answer set for inspection by the user on a video terminal, printer, or the like.

The operating system 44 will be recognized on Fig. 4 as a generalized illustration of software means for implementing the functions discussed with reference to the components 11-16 of Fig. 2 of the present invention.

## Claims

1. A method of operating a computer, within an operating environment wherein an application executes as multiple loadable program units, for identifying one of said program units, comprising the steps of:
generating at least one dynamic link library;
generating a plurality of code selectors;
generating a first code module in said at least one of said dynamic link libraries related to said plurality of code selectors;
deriving a first function corresponding to said dynamic link libraries and said plurality of code selectors; and
generating an indication corresponding to said first function.

2. A method according to claim 1 further comprising the step of:
preselecting said dynamic link library;
wherein said first function relates one of said code selectors to a given said preselected one of said dynamic links.

3. A method according to claim 1 or claim 2 further comprising the step of:
preselecting one of said code selectors;
wherein said first function further relates one of said dynamic link libraries to a given said preselected one of said code selectors.

4. A method according to claim 2 or claim 3 further comprising the steps of:
detecting a first of said code selectors of one of said dynamic link libraries; and
detecting the number of said code selectors in said one of said dynamic link libraries.

5. A method according to claim 4 wherein said step of detecting said first code selector further comprises the steps of:
deriving a second function; and
generating a first pointer to said second function;
wherein said detecting said first of said code selectors is in response to said first pointer to said second function.

6. A method according to claim 5 wherein said second function is in said first code module.

EP 0 336 552 A2

7. A method according to claim 6 further comprising the steps of:
generating a third function for determining a last of said code selectors corresponding to said preselected one of said dynamic link libraries; and
calling said third function to determine said last of said code selectors.

8. A method according to claim 7 wherein said third function is an assembler language function.

9. A method according to claim 8 wherein said step of detecting the number of said code selectors in said one of said dynamic link libraries comprises functionally comparing said detected first of said code selectors and said last of said code selectors determined from said assembler language third function.

10. A method according to claim 9 further including the step of generating a second pointer for returning said first selector and said detected number of code selectors to a caller of said first function.

11. A method according to claim 10 wherein said pointer is comprised of a selector portion functionally related to said first code selector of said dynamic link library, and an offset portion functionally related to said detected number of code selectors in said dynamic link library.

12. A method according to claim 11 wherein said selector portion comprises said first code selector of said dynamic link library, and said offset portion comprises said detected number of code selectors in said dynamic link library.

13. A method according to claim 12 wherein said first function returning said second pointer is a dynamic link identifier function (DLIF).

14. A method according to claim 13 wherein said code selectors are identified by said DLIF.

15. A method according to claim 14 further including generating a linking process function for ordering said code selectors of said DLIF and said assembly language third function.

16. A method according to claim 15 wherein said linking process function comprises the steps of:
defining a link list for said dynamic link library;
defining a first module including said DLIF function;
associating said module with a first location in said link list;
defining a link for said dynamic link library;
defining a plurality of libraries included in said link; and
introducing a second module including said assembly language third function into one of said libraries.

17. A computer system including an operating system wherein an application executes as multiple loadable program units, means for identifying one of said program units comprising means for generating at least one dynamic link library, means for generating a plurality of code selectors, means for generating a first code module in said at least one of said dynamic link libraries related to said plurality of code selectors, means for deriving a first function corresponding to said dynamic link libraries and said plurality of code selectors, and means for generating an indication corresponding to said first function.

18. A system according to claim 16 further comprising means for preselecting one of said dynamic link libraries, and wherein said first function relates one of said code selectors to a given said preselected one of said dynamic links.

9

REAL MODE　　　　　PROTECT　MODE

2 ⟿ | SEGMENT |　　　　　　　　　　　| SELECTOR | ⟿ 5

3 ⟿ | OFFSET |　　　　| OFFSET | ⟿ 7

TABLE

6

PHYSICAL
MEMORY ⟿ 1

PHYSICAL
MEMORY ⟿ 4

**F I G. 1**

| APPLICATION |　　| APPLICATION |　　| APPLICATION |

10　　　　　　　　10　　　　　　　　10

| APPLICATION PROGRAM INTERFACE — 11 | | API EXTENSION — 12 |

| OPERATING SYS-
TEM SUBSYSTEM — 13 | OPERATING SYS-
TEM SUBSYSTEM — 13 | SUBSYSTEM — 14 |

| SYSTEM KERNEL OF OPERATING SYSTEM 　　15 |

| DEVICE
DRIVER 16 | DEVICE
DRIVER 16 | DEVICE
DRIVER 16 |

**F I G. 2**

FIG. 3

APPLICATION PROGRAMS ~10

APPLICATION 1

.
.
.

APPLICATION N

OPERATING SYSTEM ~44

I/O DEVICES 34

ROM 36

MEMORY 38

MEDIA 40

~42

PROCESSOR 32

F I G. 4